# EUROPEAN PATENT APPLICATION

(11) **EP 3 858 886 A1**
(43) Date of publication of application: **04.08.2021**
(21) Application number: 19866227.2
(22) Date of filing: 04.09.2019
(51) Int. Cl.: C08G 61/10, C08G 61/12

(54) **METHOD FOR PRODUCING POLYMER COMPOUND**

(30) Priority: 28.09.2018 JP 2018183826
(71) Applicant: Sumitomo Chemical Company, Limited, Tokyo 104-8260 (JP)
(72) Inventor: KASHIMA, Ken, Osaka-shi, Osaka 555-0021 (JP); HIROI, Yuki, Osaka-shi, Osaka 554-8558 (JP); MORI, Takuya, Osaka-shi, Osaka 554-8558 (JP)
(74) Representative: J A Kemp LLP
(86) International application number: PCT/JP2019/034747
(87) International publication number: WO 2020/066509

(57) **Abstract**

The present invention has an object of providing a production method of a polymer compound having small content of low molecular weight components.

A method of purifying a polymer compound A containing a constitutional unit represented by the formula (1) to produce a polymer compound B containing a constitutional unit represented by the formula (1) in which low molecular weight components are reduced, wherein
the above-described purification includes a step of treating a mixture containing the above-described polymer compound A and a solvent by column chromatography using an adsorbent,
the filling amount of the adsorbent in the above-described column is 300 parts by mass or more with respect to 100 parts by mass of the above-described polymer compound A,
and the mesopore volume of the above-described adsorbent is 0.3 to 0.7 cm³/g: 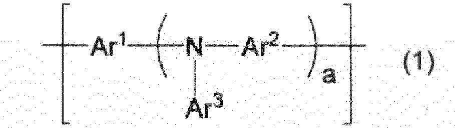 [wherein, Ar¹ and Ar² each independently represent a divalent aromatic hydrocarbon group, a divalent hetero ring group or the like, and when a plurality of Ar² are present, they may be the same or different. Ar³ represents a monovalent aromatic hydrocarbon group or the like. a represents an integer of 0 to 2.].

## Description

### Technical Field

The present invention relates to a production method of a polymer compound.

### Background Art

As materials of organic electroluminescent (hereinafter, referred to also as "organic EL") devices and the like, for example, polymer compounds are used. For improving the electrical characteristics, the life and the like of the devices, it is desirable that the content of low molecular weight components in the polymer compound is small.

The polymer compound can be synthesized, for example, by performing the Suzuki coupling reaction between an aromatic diboronic acid and an aromatic dihalide in the presence of a transition metal complex. However, in this synthesis method, it was difficult to obtain a polymer compound having sufficiently low content of low molecular weight components.

As the method capable of reducing the content of low molecular weight components in a polymer, for example, Patent Document 1 describes a method of separating the molecular weight fraction having charge transfer characteristics. Patent Document 2 describes a method for purifying an unpurified polymer compound by contacting with a carbon material (activated carbon and the like) in water.

### Prior Art Document

### Patent Document

[Patent Document 1] Japanese Translation of PCT International Application Publication (JP-T) No. 2003-503519
[Patent Document 2] International Publication WO2011/118611

### Summary of the Invention

### Problem to be Solved by the Invention

The present invention has an object of proving a production method of a polymer compound having low content of low molecular weight components.

### Means for Solving the Problem

The present inventors have intensively studied to solve the above-described problem and resultantly found that by treating a polymer compound by column chromatography using a prescribed amount of an adsorbent having a prescribed mesopore volume, the content (mass fraction) of low molecular weight components in the polymer compound can be selectively reduced. The present inventors have further investigated additionally based on such a finding, leading to completion of the present invention.

The present invention provides the following [1] to [5].
[1] A method of purifying a polymer compound A containing a constitutional unit represented by the formula (1) (hereinafter, referred to as polymer compound A in some cases) to produce a polymer compound B containing a constitutional unit represented by the formula (1) in which low molecular weight components are reduced (hereinafter, referred to as polymer compound B in come cases), wherein
   the above-described purification includes a step of treating a mixture containing the above-described polymer compound A and a solvent by column chromatography using an adsorbent,
   the filling amount of the adsorbent in the above-described column is 300 parts by mass or more with respect to 100 parts by mass of the above-described polymer compound A,
   and the mesopore volume of the above-described adsorbent is 0.3 to 0.7 cm³/g: 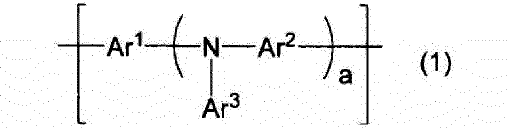 [wherein,
   Ar¹ and Ar² each independently represent a divalent aromatic hydrocarbon group, a divalent hetero ring group, or a divalent group in which a divalent aromatic hydrocarbon group and a divalent hetero ring group are bonded, and these groups optionally have a substituent. When a plurality of Ar² are present, they may be the same or different.
   Ar³ represents a monovalent aromatic hydrocarbon group or a monovalent hetero ring group, and these groups optionally have a substituent. When a plurality of Ar³ are present, they may be the same or different.
   a represents an integer of 0 to 2.].
[2] The production method according to [1], wherein the above-described adsorbent is at least one selected from activated clay and activated carbon.
[3] The production method according to [1] or [2], wherein the weight-average molecular weight of the above-described polymer compound A is over 20000.
[4] The production method according to any one of [1] to [3], further including a step of performing a reprecipitation treatment, after the step of performing the above-described column chromatography treatment.
[5] A method of purifying a polymer compound A having a constitutional unit represented by the formula (1), wherein
   the above-described purification includes a step of treating a mixture containing the above-described polymer compound A and a solvent by column chromatography using an adsorbent,
   the filling amount of the adsorbent in the above-described column is 300 parts by mass or more with respect to 100 parts by mass of the above-described polymer compound A,
   and the mesopore volume of the above-described adsorbent is 0.3 to 0.7 cm³/g.

### Effect of the Invention

According to the method of the present invention, a polymer compound having sufficiently low content of low molecular weight components having a molecular weight of 20000 or less can be produced.

### Brief Explanation of Drawing

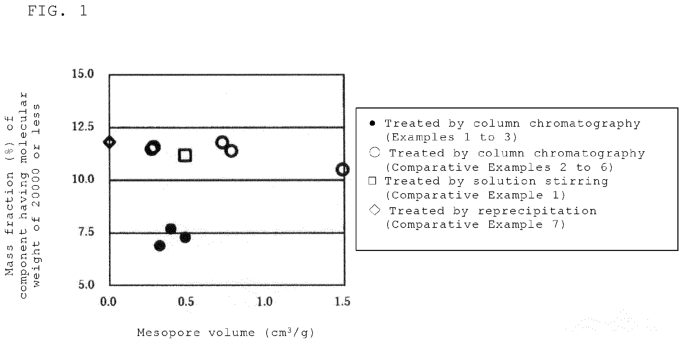

FIG. 1 is a graph showing the relation between the mesopore volume of adsorbents used in Examples 1 to 3 and Comparative Examples 1 to 7 and the mass fraction of low molecular weight (molecular weight: 20000 or less) components contained in the resultant polymer compounds.

### Modes for Carrying Out the Invention

### 1. Explanation of common terms

Terms used in the present specification will be explained below.

"The hydrogen atom" may be a light hydrogen atom or a heavy hydrogen atom.

"The alkyl group" means a linear, branched or cyclic alkyl group. The number of carbon atoms of the linear alkyl group is usually 1 to 50, preferably 3 to 30, and more preferably 4 to 20. The number of carbon atoms of the branched or cyclic alkyl group is usually 3 to 50, preferably 3 to 30, and more preferably 4 to 20. The alkyl group includes, for example, a methyl group, an ethyl group, a n-propyl group, an isopropyl group, a n-butyl group, an isobutyl group, a tert-butyl group, a n-pentyl group, an isoamyl group, a 2-ethylbutyl group, a n-hexyl group, a cyclohexyl group, a n-heptyl group, a cyclohexylmethyl group, a cyclohexylethyl group, a n-octyl group, a 2-ethylhexyl group, a 3-n-propylheptyl group, a n-decyl group, a 3,7-dimethyloctyl group, a 2-ethyloctyl group, a 2-n-hexyl-decyl group, a n-dodecyl group and the like.

"The alkyl group" optionally has a substituent, and the substituent includes, for example, a fluorine atom, a cyano group, an aryl group, a monovalent hetero ring group, an alkoxy group, an aryloxy group, a substituted amino group, a carboxyl group, an esterified carboxyl group, an alkenyl group, an alkynyl group, a metal complex-containing group and the like. "The alkyl group" optionally has 1 to 20 substituents selected from these substituents. The substituted alkyl group includes, for example, a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-n-hexylphenyl)propyl group, a 6-ethyloxyhexyl group and the like.

"The aryl group" means a monovalent group obtained by removing from an aromatic hydrocarbon one hydrogen atom bonding directly to a carbon atom constituting the ring. The number of carbon atoms of the aryl group is usually 6 to 60, preferably 6 to 20, and more preferably 6 to 10. The aryl group includes, for example, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group and the like.

"The aryl group" optionally has a substituent, and the substituent includes, for example, a fluorine atom, a cyano group, an alkyl group, an aryl group, a monovalent hetero ring group, an alkoxy group, an aryloxy group, a substituted amino group, a carboxyl group, an esterified carboxyl group, an alkenyl group, an alkynyl group, a metal complex-containing group and the like. "The aryl group" optionally has 1 to 10 substituents selected from these substituents. The substituted aryl group includes, for example, a pentafluorophenyl group, a 4-hexylphenyl group, a 4-phenylphenyl group and the like.

"The alkoxy group" means a linear, branched or cyclic alkoxy group. The number of carbon atoms of the linear alkoxy group is usually 1 to 40, and preferably 4 to 10. The number of carbon atoms of the branched or cyclic alkoxy group is usually 3 to 40, and preferably 4 to 10. The alkoxy group includes, for example, a methoxy group, an ethoxy group, a n-propyloxy group, an isopropyloxy group, a n-butyloxy group, an isobutyloxy group, a tert-butyloxy group, a n-pentyloxy group, a n-hexyloxy group, a cyclohexyloxy group, a n-heptyloxy group, a n-octyloxy group, a 2-ethylhexyloxy group, a n-nonyloxy group, a n-decyloxy group, a 3,7-dimethyloctyloxy group, a lauryloxy group and the like.

"The alkoxy group" optionally has a substituent, and the substituent includes, for example, a fluorine atom, a cyano group, an aryl group, a monovalent hetero ring group, an alkoxy group, an aryloxy group, a substituted amino group, a carboxyl group, an esterified carboxyl group, an alkenyl group, an alkynyl group, a metal complex-containing group and the like. "The alkoxy group" optionally has 1 to 10 substituents selected from these substituents.

"The aryloxy group" means a monovalent group obtained by substituting one hydrogen atom bonding directly to a carbon atom constituting the ring of an aromatic hydrocarbon with an oxygen atom. The number of carbon atoms of the aryloxy group is usually 6 to 60, and preferably 7 to 48. The aryloxy group includes, for example, a phenoxy group, a 1-naphthyloxy group, a 2-naphthyloxy group, a 1-anthracenyloxy group, a 9-anthracenyloxy group, a 1-pyrenyloxy group and the like.

"The aryloxy group" optionally has a substituent, and the substituent includes, for example, a fluorine atom, a cyano group, an alkyl group, a monovalent hetero ring group, an alkoxy group, an aryloxy group, a substituted amino group, a carboxyl group, an esterified carboxyl group, an alkenyl group, an alkynyl group, a metal complex-containing group and the like. "The aryloxy group" optionally has 1 to 10 substituents selected from these substituents. The substituted aryloxy group includes, for example, a pentafluorophenoxy group, a 4-hexylphenoxy group, a 4-phenylphenoxy group and the like.

"The substituted amino group" means an amino group having two substituents. The substituent includes, for example, an alkyl group, an aryl group (the aryl group optionally has an alkyl group), a monovalent hetero ring group and the like. The substituted amino group includes, for example, a dialkylamino group, a diaryl amino group and a di(mono or dialkyl aryl)amino group, and specifically includes, for example, a dimethylamino group, a diethylamino group, a diphenylamino group, a bis(4-methylphenyl)amino group, a bis(4-tert-butylphenyl)amino group, a bis(3,5-di-tert-butylphenyl)amino group and the like.

"The esterified carboxyl group" means a group represented by the formula: -COOR' (R' represents an alkyl group, an aryl group, a monovalent hetero ring group or the like). The esterified carboxyl group includes, for example, an alkyloxycarbonyl group and an aryloxycarbonyl group, and specifically includes, for example, a group represented by -CO₂CH₃, a group represented by -CO₂C₂H₅, a group represented by - CO₂C₆H₅, and the like.

"The alkenyl group" may be any of linear, branched and cyclic. The number of carbon atoms of the linear alkenyl group is usually 2 to 30, and preferably 2 to 20. The number of carbon atoms of the branched or cyclic alkenyl group is usually 3 to 30, and preferably 4 to 20. The alkenyl group includes, for example, a vinyl group, a 1-propenyl group, a 2-propenyl group, a 2-buten-1-yl group, a 3-buten-1-yl group, a 1-cyclohexenyl group, a 1-norbornyl group, a 2-norbornyl group and the like.

"The alkenyl group" optionally has a substituent, and the substituent includes, for example, a fluorine atom, a cyano group, an aryl group, a monovalent hetero ring group, an alkoxy group, an aryloxy group, a substituted amino group, a carboxyl group, an esterified carboxyl group, a metal complex-containing group and the like. "The alkenyl group" optionally has 1 to 20 substituents selected from these substituents. The substituted alkenyl group includes, for example, a 2-phenylethenyl group, a 4-octyl-2-phenylethenyl group and the like.

"The alkynyl group" may be any of linear, branched and cyclic. The number of carbon atoms of the linear alkynyl group is usually 2 to 30, and preferably 2 to 20. The number of carbon atoms of the branched or cyclic alkynyl group is usually 4 to 30, and preferably 4 to 20. The alkynyl group includes, for example, an ethynyl group, a 1-propynyl group, a 2-propynyl group, a 2-butyn-1-yl group, a 3-butyn-1-yl group and the like.

"The alkynyl group" optionally has a substituent, and the substituent includes, for example, a fluorine atom, a cyano group, an aryl group, a monovalent hetero ring group, an alkoxy group, an aryloxy group, a substituted amino group, a carboxyl group, an esterified carboxyl group, a metal complex-containing group and the like. "The alkynyl group" optionally has 1 to 20 substituents selected from these substituents. The substituted alkynyl group includes, for example, a 2-phenylethynyl group, a 4-octyl-2-phenylethynyl group and the like.

"The metal complex-containing group" means a group containing a complex formed from a metal atom and a ligand coordinating it. Examples thereof include groups represented by any of the formula (C-1) to the formula (C-4). 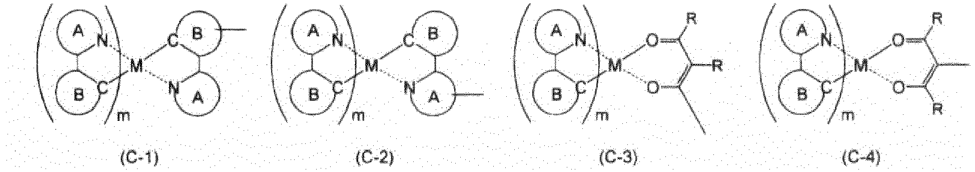 [wherein, M is Ir or Pt. m = 2 when M is Ir, while m = 1 when M is Pt. Ring A represents a cyclic structure containing a nitrogen atom optionally having a substituent. Ring B represents a cyclic structure containing a carbon atom optionally having a substituent. R represents the same meaning as described later.]

Ring A includes, for example, nitrogen-containing aromatic rings (pyridine and the like). Ring B includes, for example, aromatic rings (benzene and the like) or hetero aromatic rings (dibenzothiophene and the like). Ring A and Ring B optionally have a substituent. Ring A and Ring B each optionally have 1 to 4 substituents selected from, for example, a fluorine atom, a cyano group, an alkyl group, an aryl group, a monovalent hetero ring group, an alkoxy group, an aryloxy group, a substituted amino group, a carboxyl group, an esterified carboxyl group, an alkenyl group, an alkynyl group and the like.

"The monovalent aromatic hydrocarbon group" means a monovalent group obtained by removing from an aromatic hydrocarbon one hydrogen atom bonding directly to a carbon atom constituting the ring. The number of carbon atoms of of the aromatic hydrocarbon is usually 6 to 60, preferably 6 to 20, and more preferably 6 to 10. The monovalent aromatic hydrocarbon group includes, for example, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group and the like.

"The monovalent aromatic hydrocarbon group" optionally has a substituent, and the substituent includes, for example, a halogen atom (particularly a fluorine atom), a cyano group, an alkyl group, an aryl group (the aryl group optionally has 1 to 3 substituents selected from the group consisting of an alkyl group and an alkoxy group), a monovalent hetero ring group, an alkoxy group, an aryloxy group, a substituted amino group, an alkylene group (a dimethylene group, a trimethylene group, etc.) and the like. "The monovalent aromatic hydrocarbon group" optionally has 1 to 10 substituents selected from these substituents. The substituted monovalent aromatic hydrocarbon group includes, for example, a 2-phenylphenyl group, a 3-phenylphenyl group, a 4-phenylphenyl group, a benzocyclobutenyl group and the like.

"The divalent aromatic hydrocarbon group" means a divalent group obtained by removing from an aromatic hydrocarbon two hydrogen atoms bonding directly to carbon atoms constituting the ring, and a divalent group obtained by bonding several (for example, 2 to 5) groups selected from the group consisting of the aforementioned divalent group. The number of carbon atoms of the divalent aromatic hydrocarbon group is usually 6 to 60, preferably 6 to 30, and more preferably 6 to 18. The divalent aromatic hydrocarbon group includes, for example, a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group and the like.

"The divalent aromatic hydrocarbon group" optionally has a substituent, and the substituent includes, for example, a fluorine atom, a cyano group, an alkyl group, an aryl group (the aryl group optionally has 1 to 5 substituents selected from the group consisting of an alkyl group, an alkoxy group, a phenyl group and an alkylphenyl group), a monovalent hetero ring group, an alkoxy group, an aryloxy group, a substituted amino group, a carboxyl group, an esterified carboxyl group, an alkenyl group, an alkynyl group, a metal complex-containing group and the like. "The divalent aromatic hydrocarbon group" optionally has 1 to 10 substituents selected from these substituents. The divalent aromatic hydrocarbon group optionally having a substituent includes, for example, groups represented by the formula (A-1) to the formula (A-20). 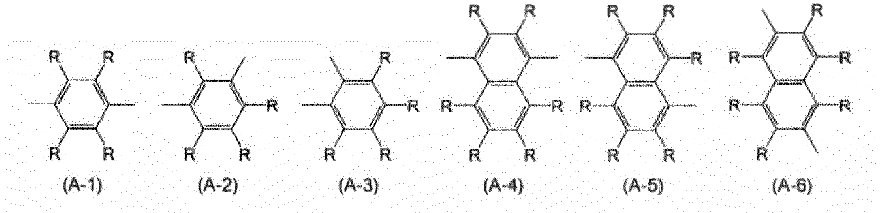 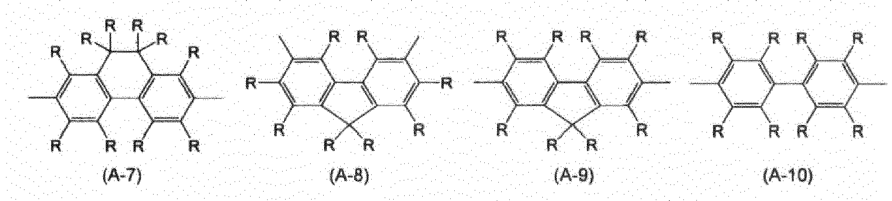 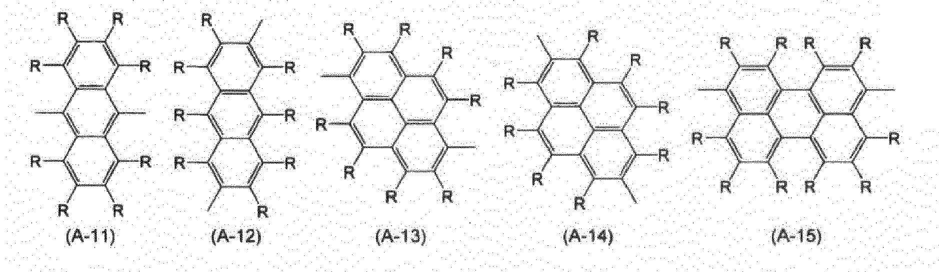 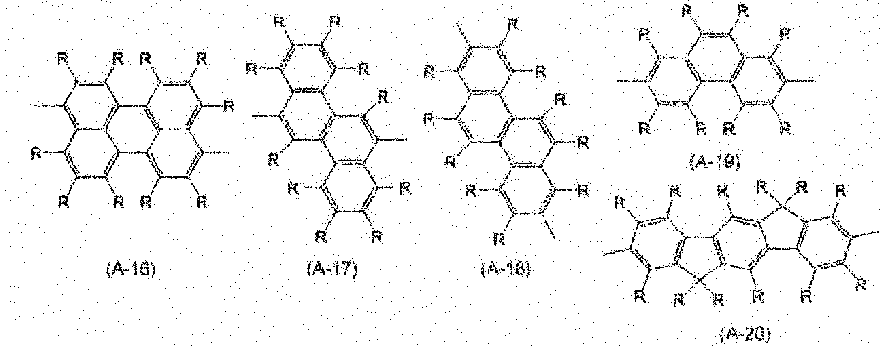 [wherein, R represents a hydrogen atom, a fluorine atom, a cyano group, an alkyl group, an aryl group, a monovalent hetero ring group, an alkoxy group, an aryloxy group, a substituted amino group, a carboxyl group, an esterified carboxyl group, an alkenyl group, an alkynyl group or a metal complex-containing group. R optionally has a substituent, when it is a substitutable group. When a plurality of R are present, they may be the same or different. Adjacent R may be combined together to form a ring together with carbon atoms to which they are attached.]

"The monovalent hetero ring group" means a monovalent group obtained by removing from a heterocyclic compound one hydrogen atom among hydrogen atoms bonding directly to carbon atoms or hetero atoms constituting the ring. Of the monovalent hetero ring groups, preferable is "a monovalent aromatic hetero ring group" which is a monovalent group obtained by removing from an aromatic heterocyclic compound one hydrogen atom among hydrogen atoms bonding directly to carbon atoms or hetero atoms constituting the ring. "The monovalent hetero ring group" includes, for example, a thienyl group, a pyrrolyl group, a furyl group, a pyridyl group, a piperidyl group, a quinolyl group, an isoquinolyl group, a pyrimidinyl group, a triazinyl group and the like.

"The aromatic heterocyclic compound" means, for example, any of a compound in which the hetero ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzosilole, dibenzophosphole and the like; a compound in which an aromatic ring is condensed to a hetero ring even if the hetero ring itself shows no aromaticity such as phenoxazine, phenothiazine, dibenzoborole, dibenzosilole, benzopyran and the like; and a compound obtained by bonding a plurality of these compounds.

"The monovalent hetero ring group" optionally has a substituent, and the substituent includes, for example, a halogen atom (particularly a fluorine atom), a cyano group, an alkyl group, an aryl group, a monovalent hetero ring group, an alkoxy group, an aryloxy group, a substituted amino group, an alkylene group and the like. The monovalent hetero ring group optionally has 1 to 5 substituents selected from these substituents.

"The divalent hetero ring group" means a divalent group obtained by removing from a heterocyclic compound two hydrogen atoms among hydrogen atoms bonding directly to carbon atoms or hetero atoms constituting the ring. Of the divalent hetero ring groups, preferable is "divalent aromatic hetero ring group" which is a divalent group obtained by removing from an aromatic heterocyclic compound two hydrogen atoms among hydrogen atoms bonding directly to carbon atoms or hetero atoms constituting the ring. "The divalent hetero ring group" includes, for example, a divalent group obtained by removing from an aromatic heterocyclic compound such as pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole, triazole, oxazole, oxadiazole, thiazole, thiadiazole and the like two hydrogen atoms among hydrogen atoms bonding directly to carbon atoms or hetero atoms constituting the ring, and a divalent group obtained by bonding a plurality of (for example, 2 to 4) groups selected from the group consisting of these divalent groups.

"The divalent hetero ring group" optionally has a substituent, and the substituent includes, for example, a fluorine atom, a cyano group, an alkyl group, an aryl group, a monovalent hetero ring group, an alkoxy group, an aryloxy group, a substituted amino group, a carboxyl group, an esterified carboxyl group, an alkenyl group, an alkynyl group, a metal complex-containing group and the like. The divalent hetero ring group optionally has 1 to 5 substituents selected from these substituents. The divalent hetero ring group optionally having a substituent is preferably a group represented by the formula (A-21) to the formula (A-45) . 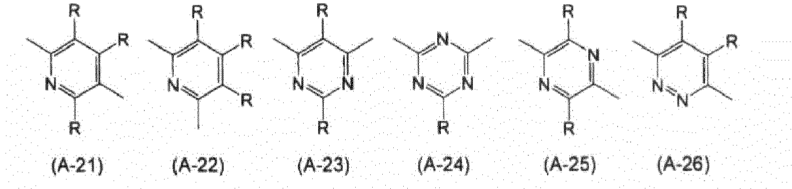 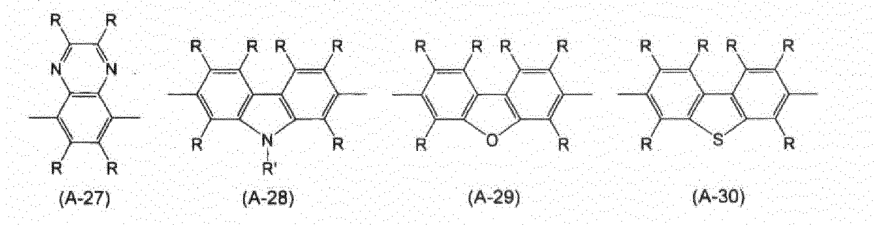 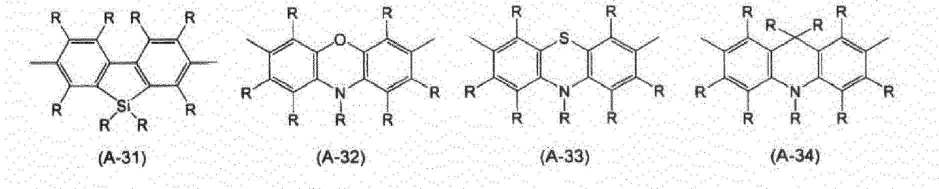 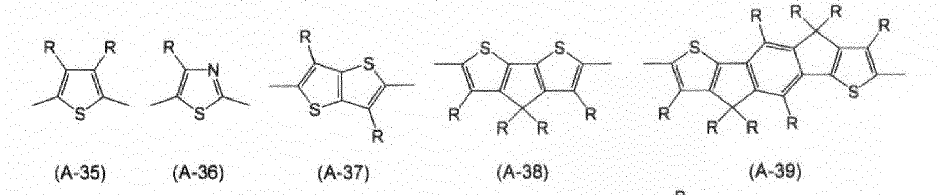 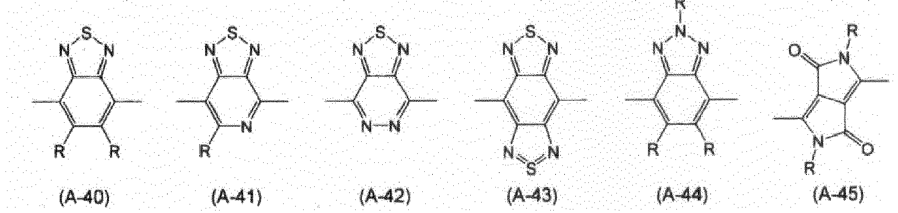 [wherein, R and R' represent the same meaning as described above. When a plurality of R are present, they may be the same or different.]

"The divalent group in which a divalent aromatic hydrocarbon group and a divalent hetero ring group are bonded" means a divalent group in which one or two or more of the divalent aromatic hydrocarbon groups described above and one or two or more of the divalent hetero ring groups described above are arbitrarily bonded. The divalent aromatic hydrocarbon group and the divalent hetero ring group include those mentioned above.

"The divalent group in which a divalent aromatic hydrocarbon group and a divalent hetero ring group are bonded" optionally has a substituent, and its partial structure, that is, the divalent aromatic hydrocarbon group optionally has thereon 1 to 10 substituents selected from a fluorine atom, a cyano group, an alkyl group, an aryl group, a monovalent hetero ring group, an alkoxy group, an aryloxy group, a substituted amino group, a carboxyl group, an esterified carboxyl group, an alkenyl group, an alkynyl group and a metal complex-containing group described above, and the other partial structure, that is, the divalent hetero ring group optionally has thereon 1 to 5 substituents selected from a fluorine atom, a cyano group, an alkyl group, an aryl group, a monovalent hetero ring group, an alkoxy group, an aryloxy group, a substituted amino group, a carboxyl group, an esterified carboxyl group, an alkenyl group, an alkynyl group and a metal complex-containing group described above.

### 2. Production method of the present invention

The production method of the present invention is a method of purifying a polymer compound A containing a constitutional unit represented by the formula (1) to produce a polymer compound B having a constitutional unit represented by the formula (1) in which low molecular weight components are reduced characterized in that the method includes a step of treating a mixture containing the polymer compound A and a solvent by column chromatography using an adsorbent, the filling amount of the above-described adsorbent is 300 parts by mass or more with respect to 100 parts by mass of the polymer compound A, and and the mesopore volume of the above-described adsorbent is 0.3 to 0.7 cm³/g. According to this production method, low molecular weight components can be removed selectively from the polymer compound A, and the polymer compound B in which the content (mass fraction) of low molecular weight components is small can be produced.

### 2.1 Adsorbent

The adsorbent used in the present invention has a mesopore volume of 0.3 to 0.7 cm³/g. From the standpoint of more efficiently removing low molecular weight components, it is preferably 0.3 to 0.6 cm³/g, and further preferably 0.3 to 0.5 cm³/g. The mesopore usually means fine pores having a pore diameter of 2 nm to 50 nm. The mesopore volume can be measured by a nitrogen adsorption method.

The type of the adsorbent is not particularly restricted providing it has the above-described mesopore volume and includes, for example, clay, activated carbon and inorganic oxide. The clay includes, for example, activated clay, acid clay, bentonite and kaolinite. The inorganic oxide includes, for example, activated alumina (AlO₃), silica gel (SiO₂) and magnesium silicate (MgSiO₃). The adsorbent is preferably clay or activated carbon, and more preferably activated clay or activated carbon. The adsorbent can be used singly or in combination of two or more selected from the above-described substances.

The use amount of the adsorbent is preferably 500 parts by mass or more, more preferably 1000 parts by mass or more, and further preferably 1500 parts by mass or more, with respect to 100 parts by mass of the polymer compound A, from the standpoint of removing low molecular weight components. In contrast, the use amount of the adsorbent is preferably 10000 parts by mass or less, more preferably 8000 parts by mass or less, further preferably 6000 parts by mass or less, and particularly preferably 3000 parts by mass or less, with respect to 100 parts by mass of the polymer compound A, from the standpoint of increasing the recovery ratio of the polymer compound B.

The zeta potential can be used as the index showing the magnitude of charge on the particle surface of the adsorbent.

The absolute value of the zeta potential of the adsorbent in pure water of pH 7 is preferably 1 to 70 mV, more preferably 15 to 50 mV, and further preferably 20 to 40 mV. If the above-described absolute value of the zeta potential satisfies such ranges, low molecular weight components tend to be further reduced. The zeta potential can be measured by an electrophoresis method.

The average particle diameter of the adsorbent is preferably 20 to 65 µm, more preferably 22 to 50 µm, further preferably 22 to 45 µm, and particularly preferably 22 to 40 µm, from the standpoint of removing low molecular weight components. The average particle diameter means volume-based cumulative 50% particle diameter, and can be measured using a laser diffraction scattering particle size distribution measurement apparatus.

### 2.2 Column chromatography

The production method of the present invention is characterized by using a column chromatography treatment of passing a mixture containing the polymer compound A and a solvent through a column filled with an adsorbent to separate and remove low molecular weight components. Specifically, it is a method in which an adsorbent filled in a column is used as the stationary phase, a mixture containing the polymer compound A and a solvent is used as the mobile phase, the polymer compound A is used as the solute to be separated, and low molecular weight components in the polymer compound A are separated and removed by utilizing a difference in mutual action occurring between the stationary phase (adsorbent) and the polymer compound A in the mobile phase.

The method of filling an adsorbent in a column is not particularly restricted, and includes typically a method in which an adsorbent and a solvent are brought into mutual contact to prepare a slurry before filling, a method of filling an adsorbent in the form a solid, a method in which an adsorbent is filled in the form of solid, then, immersed in a solvent the replace a gas in the adsorbent with the solvent; and the like. The method in which the solid adsorbent is filled, then, immersed in a solvent to replace a gas in the adsorbent with with solvent is preferred, from the standpoint of easily removing low molecular weight components. As described above, the amount of the adsorbent to be filled in a column is 300 parts by mass or more with respect to 100 parts by mass of the polymer compound A.

The column chromatography treatment can be carried out usually by passing a mixture containing the polymer compound and a solvent (usually, a solution containing the polymer compound A) through a column filled with an adsorbent and a solvent. The solution passed through a column can be recovered, to obtain a polymer compound B from which low molecular weight components have been removed. Moreover, after passing the mixture, a solvent (developing solvent) can be further passed. Further, it is also possible that the solution passed through a column is separated into two or more fractions, and fractions from which low molecular weight components have been effectively removed are collected, to give a polymer compound B.

The treatment time of column chromatography is not particularly restricted, from the standpoint of removing low molecular weight components. For example, it is preferably 1 hour or more, more preferably 2 hours or more, and further preferably 3 hours or more.

The column chromatography treatment with an adsorbent of the present invention can be carried out by repeating the above-described treatment once, or twice or more times.

### 2.3 Solvent

The solvent is not particularly restricted, providing it is a solvent capable of dissolving the polymer compound A containing a constitutional unit represented by the formula (1), namely, a good solvent for the polymer compound A.

The solvent (a good solvent for the polymer compound A) can be selected from various solvents depending on the property of the polymer compound A. Specifically, the solvent can be defined as a solvent with which the degree of solubility (20°C) of the polymer compound A is 1 g/100 g or more.

The solvent includes, for example, aromatic hydrocarbon solvents such as toluene, xylene, mesitylene, cyclohexylbenzene, tetralin and the like; ether solvents such as tetrahydrofuran, 1,4-dioxane, dimethoxyethane, anisole and the like; amide solvents such as N,N-dimethylacetamide, N,N-dimethylformamide, N-methyl-2-pyrrolidone and the like; alcohol solvents such as methanol, ethanol, ethylene glycol, isopropyl alcohol, propylene glycol, ethylene glycol monomethyl ether, ethylene glycol monobutyl ether and the like; ketone solvents such as acetone, methyl ethyl ketone, cyclopentanone, cyclohexanone, methyl amyl ketone, methyl isobutyl ketone and the like; aliphatic hydrocarbon solvents such as pentane, hexane, heptane and the like; nitrile solvents such as acetonitrile and the like; halogenated hydrocarbon solvents such as chloroform and the like; ester solvents such as methyl acetate, ethyl acetate and the like; etc. The solvents may be used singly or in combination of two or more, and further, may be used in combination with water.

Of them, the solvents are preferably aromatic hydrocarbon solvents and ether solvents, more preferably aromatic hydrocarbon solvents, and further preferably toluene, xylene and mesitylene.

The use amount of the solvent used for the column chromatography treatment is usually 100 to 1000000 parts by mass, and preferably 1000 to 100000 parts by mass, with respect to 100 parts by mass of the polymer compound A.

### 2.4 Polymer compound A

The polymer compound to be purified in the present invention can be obtained by polymerizing prescribed monomers, and is a compound having two or more repeating units derived from the monomer (hereinafter, referred to also as constitutional unit). Specifically, the polymer compound includes, for example, the polymer compounds A described above containing a constitutional unit represented by the formula (1). The polymer compound A containing a constitutional unit represented by the formula (1) contains the constitutional unit represented by the formula (1) as an essential component, and if necessary, may contain other constitutional units than the constitutional unit represented by the formula (1) (for example, alkylene groups (e.g., -(CH₂)-), -O-, -S-, -(CO)-, combinations thereof, and the like). Particularly, the constitutional unit A composed of a constitutional unit represented by the formula (1) is preferred.

The polymer compound A has molecular weight distribution and has a polystyrene-equivalent weight-average molecular weight (Mw) preferably in the range of 1×10³ to 1×10⁸, more preferably in the range of 1×10⁴ to 1×10⁶, and further preferably in the range of 3×10⁴ to 5×10⁵. The polystyrene-equivalent weight-average molecular weight (Mw) and the mass fraction of low molecular weight (molecular weight: 20000 or less) components can be measured according to descriptions of examples.

Ar¹ and Ar² in the constitutional unit represented by the formula (1) represent preferably a divalent aromatic hydrocarbon group or a divalent hetero ring group, and more preferably a divalent aromatic hydrocarbon group. These groups optionally have a substituent (particularly, an alkyl group and an aryl group are mentioned, and these groups optionally further have a substituent).

The divalent aromatic hydrocarbon group represented by Ar¹ and Ar² is preferably a group represented by the formula (A-1) to the formula (A-3), the formula (A-8) or the formula (A-9), and more preferably a group resented by the formula (A-1) or the formula (A-9).

The divalent hetero ring group represented by Ar¹ and Ar² is preferably a group resented by the formula (A-24) or the formula (A-35).

In the formula (1), a is preferably 0 or 1.

Examples of the constitutional unit represented by the formula (1) include constitutional units represented by the formula (1-1) to the formula (1-20), preferably constitutional units represented by the formula (1-1) to the formula (1-4), the formula (1-9) to the formula (1-11), the formula (1-15), the formula (1-16) or the formula (1-20), and more preferably constitutional units represented by the formula (1-1) to the formula (1-3), the formula (1-9) to the formula (1-11), the formula (1-15) or the formula (1-20). However, the examples are not limited to these exemplified constitutional units. 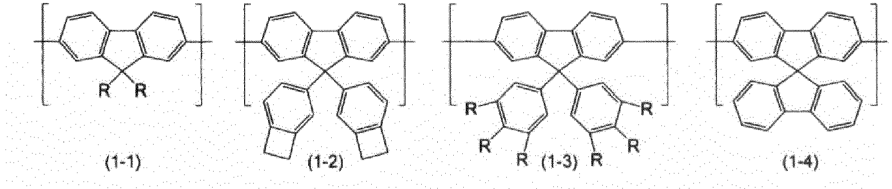 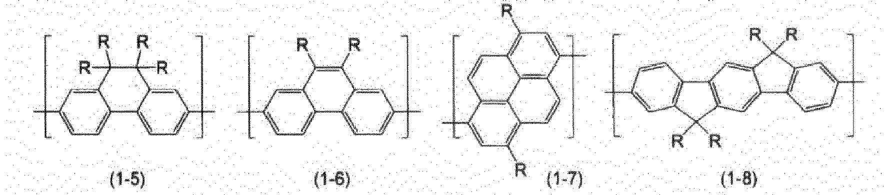 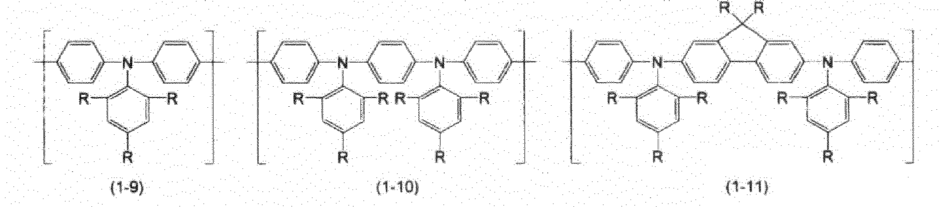 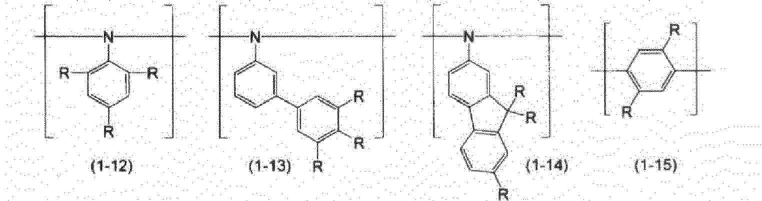 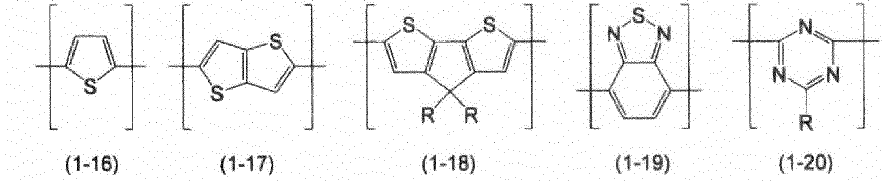 [wherein, R represents the same meaning as described above. When a plurality of R are present, they may be the same or different.]

In the constitutional unit represented by the formula (1), at least one of Ar¹ , Ar² and Ar³ may have a group containing a crosslinkable group as a substituent. The group containing a crosslinkable group includes, for example, groups represented by the formula (2).

-L-Y (2)

[wherein, L represents a single bond, or, -(CH₂)-, -O-, -S-, -(CO)-, -(C₆H₄)-, or a divalent group obtained by bonding two or more groups selected from them. However, -O- groups, -S- groups, or -O- and -S-, do not connect directly to each other. Y represents a crosslinkable group. When a plurality of Y are present, they may be the same or different.]

L includes, for example, -(CH₂)ₘ- (m represents an integer of 0 to 20), -(CH₂)ₚ-(C₆H₄)-(CH₂)_{q}- (p represents an integer of 0 to 10, q represents an integer of 0 to 10), -(CH₂)ᵣ-O-(CH₂)ₛ- (r represents an integer of 0 to 10, s represents an integer of 0 to 10), -(CH₂)ₜ-(C₆H₄)-O-(CH₂)ᵤ- (t represents an integer of 0 to 10, u represents an integer of 0 to 10), and the like.

The crosslinkable group represented by Y is preferably a group selected from Group A of crosslinkable group.

### <Group A of crosslinkable group>

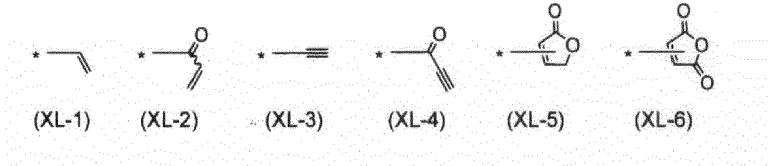

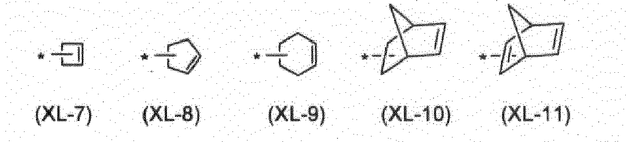

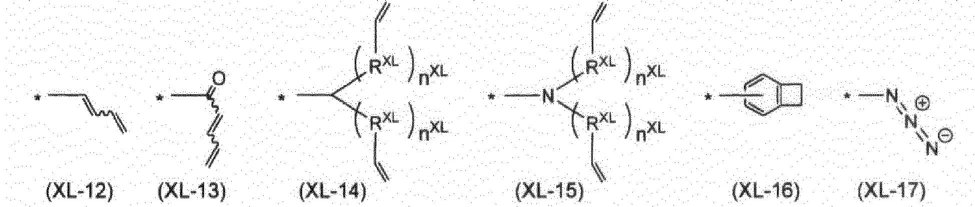

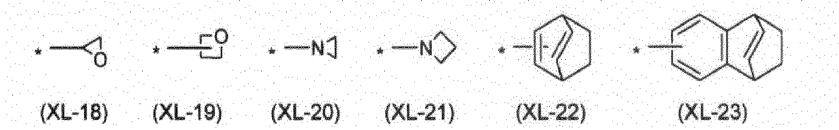

[wherein, these groups each optionally have a substituent selected from the group consisting of an alkyl group and an aryl group. R^{XL} represents -(CH₂)-, -O-, -S-, -(CO)-, or a divalent group obtained by bonding two or more groups selected from them. However, -O- groups, -S- groups, or -O- and -S-, do not connect directly to each other. n^{XL} represents an integer of 0 to 5. When a plurality of R^{XL} are present, they may be the same or different, and a plurality of n^{XL} may be the same or different. * is a site binding to L.]

In Group A of crosslinkable group, groups represented by the formula (XL-1), the formula (XL-7) to the formula (XL-16), the formula (XL-18), the formula (XL-19), the formula (XL-22) or the formula (XL-23) are preferable, groups represented by the formula (XL-1), the formula (XL-10), the formula (XL-12), the formula (XL-16), the formula (XL-18) or the formula (XL-19) are more preferable, groups represented by the formula (XL-1), the formula (XL-16) or the formula (XL-19) are further preferable, and groups represented by the formula (XL-1) or the formula (XL-16) are particularly preferable.

Specific examples of the monomer having a crosslinkable group include compounds having a structure presented by the formula (2-1) to the formula (2-30) and the formula (2'-1) to the formula (2'-9) described below. These optionally have a substituent.

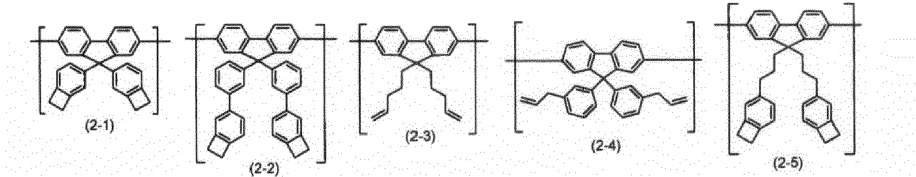

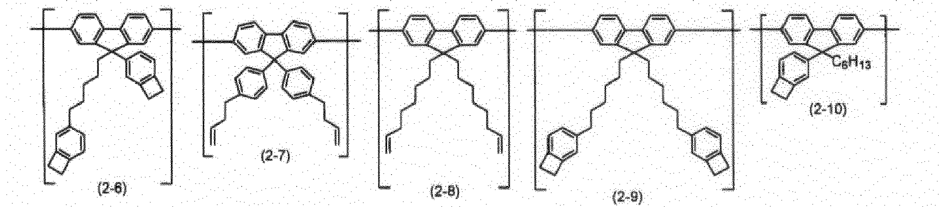

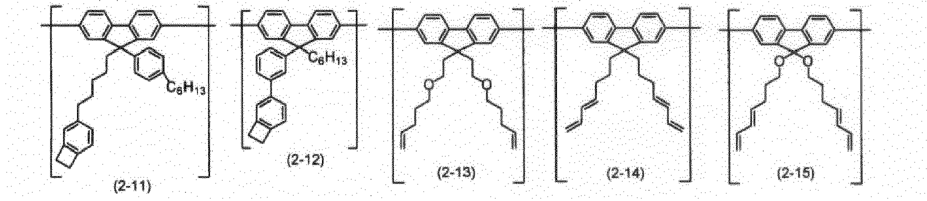

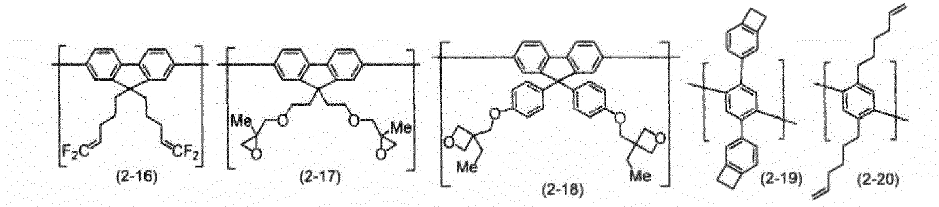

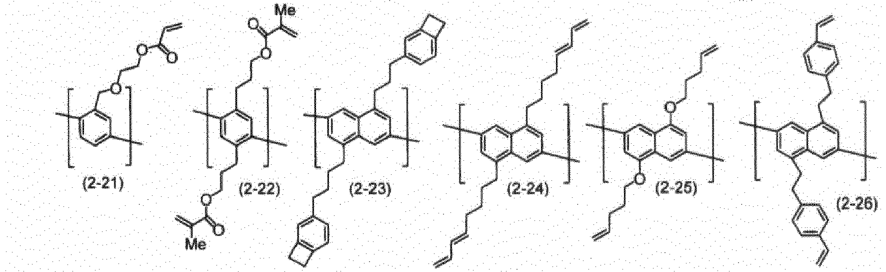

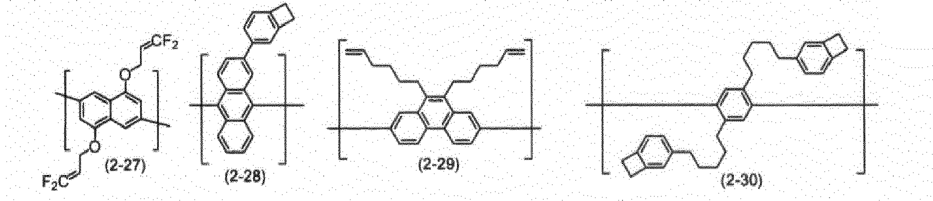

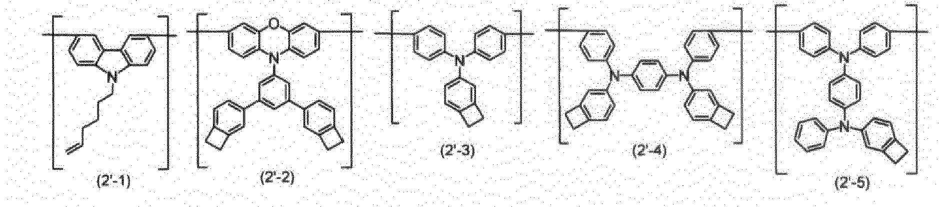

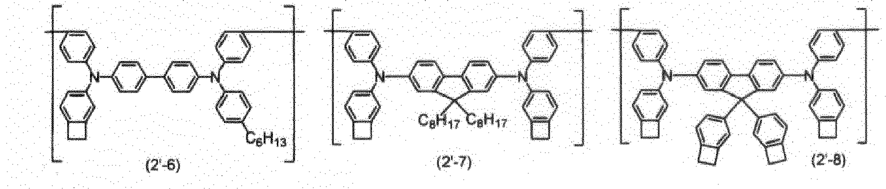

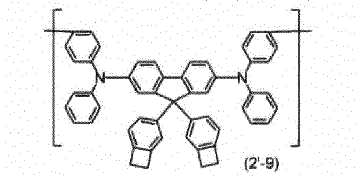

The polymer compound A containing a constitutional unit represented by the formula (1) includes polymer compounds containing one or two or more constitutional units selected from the above-described constitutional units.

The polymer compound A containing a constitutional unit represented by the formula (1) can be obtained, for example, by polymerizing a monomer containing a chlorine atom or a bromine atom, or coupling-polymerizing a monomer containing a chlorine atom or a bromine atom and a metal compound. As the polymerization method, known methods can be adopted, and examples thereof include a method of polymerizing a monomer by the Suzuki coupling reaction, a method of polymerizing a monomer by the Buchwald coupling reaction, a method of polymerizing a monomer by the Stille coupling reaction, a method of polymerizing a monomer by the Kumada coupling reaction, a method of polymerizing a monomer by the Yamamoto coupling reaction, and the like, and preferable are a method of polymerizing a monomer by the Suzuki coupling reaction and a method of polymerizing a monomer by the Buchwald coupling reaction, from the standpoint of easiness of structure control.

### 2.5 Mixture containing polymer compound A and solvent

The mixture containing the polymer compound A and a solvent is usually in a form (for example, a liquid composition, a solution or the like) which can be the mobile phase of a column chromatography treatment. Examples thereof include a solution prepared by dissolving a solid polymer compound A in a solvent, a solution after reaction obtained from a monomer by the polymerization reaction, a solution after purification obtained by purifying a polymer compound from the solution after reaction, and the like. As the solvent, solvents described in the above-described section of "2.3 Solvent" can be used.

The content (concentration) of the polymer compound A in the mixture is usually 0.01 to 50% by mass, preferably 0.1 to 10% by mass, more preferably 0.5 to 5% by mass, and further preferably 1 to 4% by mass.

### 2.6 Polymer compound B

According to the production method of the present invention, low molecular weight components can be effectively removed from the polymer compound A to obtain a polymer compound B having reduced content of low molecular weight components. Hence, the polymer compound B obtained by the production method of the present invention is suitably used as materials of organic EL devices, materials of organic photoelectric conversion devices, materials of organic transistor devices, and the like.

The polymer compound B is basically a compound containing a constitutional unit represented by the formula (1), similarly to the polymer compound A. However, the polymer compound B has larger weight-average molecular weight as compared with the polymer compound A, since low molecular weight components have been removed by a column chromatography treatment.

The polystyrene-equivalent weight-average molecular weight (Mw) of the polymer compound B is preferably in the range of 2×10³ to 1×10⁸, more preferably in the range of over 2×10⁴ and 1×10⁶ or less, and further preferably in the range of 4×10⁴ to 5×10⁵. The polystyrene-equivalent weight-average molecular weight (Mw) of the polymer compound B is usually over 20000.

The mass fraction of low molecular weight (molecular weight: 20000 or less) components of the polymer compound B obtained by the above-described column chromatography treatment is reduced significantly as compared with that of the polymer compound A before the treatment. For example, the mass fraction of low molecular weight components of the polymer compound B obtained by one column chromatography treatment is reduced usually to 70% or less, further to 65% or less, still further to 60% or less, and particularly to 40% or less, as compared with that of the polymer compound A before the treatment.

The polymer compound B obtained by the above-described column chromatography treatment can be taken out as a solid by a known method. The known method includes, for example, a reprecipitation method of allowing it to contact with a poor solvent, a method of removing a solvent under reduced pressure, a method of distilling off a solvent with heating, and the like. Preferable is a method in which a solid obtained by a reprecipitation method is further heated, dried under reduced pressure, and taken out in the form of solid.

It is preferable to conduct a reprecipitation method (a step of performing a reprecipitation treatment), after the step of the above-described column chromatography treatment.

The reprecipitation method can be carried out usually by bringing a solution containing a polymer compound B and its good solvent into contact with a poor solvent. Examples thereof include a method of adding a poor solvent to a solution containing a polymer compound B and its good solvent and stirring the mixture, a method of adding a solution containing a polymer compound B and its good solvent to a poor solvent and stirring the mixture, and the like.

The good solvent can be selected from various solvents depending on the property of the polymer compound B. For example, it can be selected from good solvents for the polymer compound A described in the above-described section of "2.3 Solvent". Of them, aromatic hydrocarbon solvents and ether solvents are preferable, aromatic hydrocarbon solvents are more preferable, and toluene, xylene and mesitylene are further preferable. The use amount of the good solvent is usually 10 to 1000 parts by mass, and preferably 50 to 300 parts by mass, with respect to 1 part by mass of the polymer compound B.

The poor solvent can be defined as a solvent with which the degree of solubility (20°C) of the polymer compound B is less than 1 g/100 g. Examples thereof include amide solvents, alcohol solvents, ketone solvents, aliphatic hydrocarbon solvents, ester solvents and nitrile solvents, and preferable are alcohol solvents. The amide solvent includes N-methyl-2-pyrrolidone and the like. The alcohol solvent includes methanol, ethanol, isopropanol and the like. The ketone solvent includes acetone, methyl ethyl ketone and the like. The ester solvent includes methyl acetate, ethyl acetate and the like. Of them, methanol, ethanol, isopropanol, acetone and ethyl acetate are preferable, and methanol is more preferable.

The use amount of the poor solvent is usually 10 to 10000 parts by mass, and preferably 50 to 3000 parts by mass, with respect to 1 part by mass of the polymer compound B.

### 3. Other step

The method of producing the polymer compound B of the present invention can include other steps than the column chromatography treatment and the reprecipitation treatment described above. Examples thereof include a polymerization step; a step of blocking the terminal of a polymer compound after polymerization; a liquid-separation step of mixing organic layer with at least one of an acid, alkali, water, saline and the like and separating organic layer from an aqueous layer and purifying the polymer compound A ; an azeotropic dehydration step of azeotropically dehydrating at normal pressure or under reduced pressure; a continuous extraction step with a Soxhlet extractor; a step of purifying by a column chromatography treatment using an adsorbent other than the above-described adsorbent; a crystallization step; and the like.

### EXAMPLES

Examples will be shown below for illustrating the present invention further in detail, but the present invention is not limited to them.

### <Molecular weight analysis>

The polystyrene-equivalent weight-average molecular weight (Mw) of a polymer compound and the mass fraction of components having a molecular weight of 20000 or less were determined by gel permeation chromatography (GPC). The mass fraction of low molecular weight (molecular weight: 20000 or less) components is a value expressed as a percentage of the ratio of the peak area after the retention time when the polystyrene-equivalent molecular weight reaches 20000 to the total peak area derived from the polymer compound A in peaks derived from the polymer compound A obtained by GPC.

The analysis conditions are as described below.
Measurement apparatus: HLC-8320GPC (manufactured by Tosoh Corp.)
Column: PLgel 10 µm MIXED-B (manufactured by Tosoh Corp.)
Column temperature: 40°C
Mobile phase: tetrahydrofuran
Flow rate: 0.5 mL/min
Detection wavelength: 228 nm

### <Mesopore volume of adsorbent>

The mesopore volume of an adsorbent was determined by a nitrogen adsorption method as described below. For an adsorbent vacuum-deaerated at 120°C for 8 hours, an adsorption/desorption isothermal line of nitrogen at an adsorption temperature of 77K was measured by a constant volume method using a fine pore distribution measurement apparatus (manufactured by MicrotracBEL Corp., trade name: BELSORP-mini). The desorption process was analyzed by the Barret-Joyner-Halenda method (Journal of the American Chemical Society, 1951, pp. 373 to 380), to obtain a fine pore distribution curve. The mesopore volume was determined by integrating the amounts of desorption of a nitrogen gas in the pore diameter range of 2 nm or more and 50 nm or less.

### <Absolute value of zeta potential>

The zeta potential was determined by an electrophoresis method as described below. An adsorbent was dispersed in water at a concentration of 2 g/L, and the zeta potential thereof was measured at 25°C by a zeta potential measurement apparatus (manufactured by Spectris Co., Ltd., trade name: Zetasizer Nano ZS). The zeta potential was analyzed using the formula of Smoluchowski from the electrophoretic mobility.

### <Average particle diameter>

The average particle diameter was determined by placing a sample in water, dispersing it by a homogenizer for 10 minutes, then, and measuring the volume-based cumulative 50% particle diameter by a laser diffraction scattering particle size distribution measurement apparatus (manufactured by Nikkiso Co., Ltd., trade name: MT3300-EXII).

### <Production Example 1>

A polymer compound (P1) represented by the following formula (A) was produced according to a description of Synthesis Example 12 of JP-A No. 2015-110751. Mw = 1.15×10⁵, and the mass fraction of components having a molecular weight of 20000 or less = 11.8%. 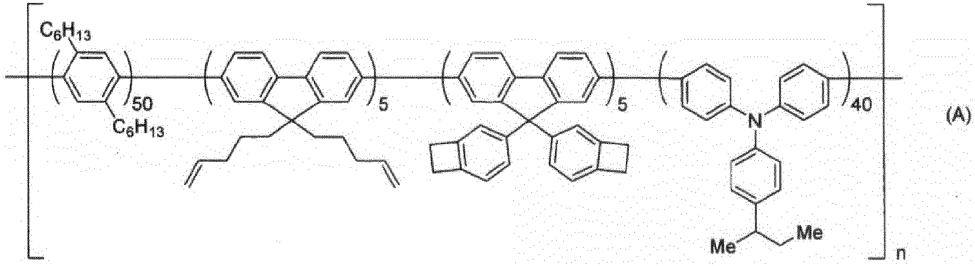 n = degree of polymerization

### <Example 1>

The polymer compound (P1) obtained in Production Example 1 was dissolved in toluene, to prepare a 1.3% by mass solution (308 g). A column tube was filled with activated clay (80 g, manufactured by Mizusawa Industrial Chemicals, Ltd., activated clay V2, mesopore volume = 0.48 cm³/g, absolute value of zeta potential = 35.7 mV, average particle diameter = 28.1 µm), it was impregnated with toluene (160 g), then, the above-described solution was added and allowed to pass through. The resultant toluene solution was dropped into methanol (2000 g) at 22°C, and the mixture was further stirred for 30 minutes. The deposited solid was taken out by filtration, and dried, to obtain a polymer compound in the form of solid (yield = 77%). The yield of the resultant polymer compound (P2) = 77%, Mw = 1.22×10⁵, and the mass fraction of components having a molecular weight of 20000 or less = 7.3%.

### <Example 2>

The same treatment as in Example 1 was conducted except that activated carbon (80 g, manufactured by Junsei Chemical Co., Ltd., mesopore volume = 0.32 cm³/g, absolute value of zeta potential = 31.2 mV, average particle diameter = 24.2 µm) was used instead of activated clay (80 g, manufactured by Mizusawa Industrial Chemicals, Ltd., activated clay V2, mesopore volume = 0.48 cm³/g, absolute value of zeta potential = 35.7 mV, average particle diameter = 28.1 µm). The yield of the resultant polymer compound (P2) = 56%, Mw = 1.26×10⁵, and the mass fraction of components having a molecular weight of 20000 or less = 6.9%.

### <Example 3>

The same treatment as in Example 1 was conducted except that activated clay (80 g, manufactured by FIJIFILM Wako Pure Chemical Corporation, mesopore volume = 0.39 cm³/g, absolute value of zeta potential = 35.5 mV, average particle diameter = 29.1 µm) was used instead of activated clay (80 g, manufactured by Mizusawa Industrial Chemicals, Ltd., activated clay V2, mesopore volume = 0.48 cm³/g, absolute value of zeta potential = 35.7 mV, average particle diameter = 28.1 µm). The yield of the resultant polymer compound (P2) = 80%, Mw = 1.21×10⁵, and the mass fraction of components having a molecular weight of 20000 or less = 7 .7%.

### <Comparative Example 1>

The polymer compound (P1) obtained in Production Example 1 was dissolved in toluene, to prepare a 1.3% by mass solution (308 g). To this solution were added activated clay (8 g, manufactured by Mizusawa Industrial Chemicals, Ltd., activated clay V2, mesopore volume = 0.48 cm³/g, absolute value of zeta potential = 35.7 mV, average particle diameter = 28.1 µm) and toluene (160 g), and the mixture was stirred for 30 minutes. Thereafter, activated clay was removed by filtration, and the resultant solution was dropped into methanol (2000 g) at 22°C, and the mixture was further stirred for 30 minutes. The deposited solid was taken out by filtration, and dried, to obtain a polymer compound in the form of solid. The yield of the resultant polymer compound (P2) = 77%, Mw = 1.16×10⁵, and the mass fraction of components having a molecular weight of 20000 or less = 11.2%.

When only the amount of activated clay used was increased under the above conditions, stirring became difficult and the dischargeability of the solution during filtration deteriorated.

### <Comparative Example 2>

The same treatment as in Example 1 was conducted except that acid clay (80 g, manufactured by Mizusawa Industrial Chemicals, Ltd., acid clay #300, mesopore volume = 0.28 cm³/g, absolute value of zeta potential = 35.0 mV, average particle diameter = 21.0 µm) was used instead of activated clay (80 g, manufactured by Mizusawa Industrial Chemicals, Ltd., activated clay V2, mesopore volume = 0.48 cm³/g, absolute value of zeta potential = 35.7 mV, average particle diameter = 28.1 µm). The yield of the resultant polymer compound (P2) = 76%, Mw = 1.16×10⁵, and the mass fraction of components having a molecular weight of 20000 or less = 11.6%.

### <Comparative Example 3>

The same treatment as in Example 1 was conducted except that activated alumina (80 g, manufactured by Wako Pure Chemical Industries, Ltd., mesopore volume = 0.27 cm³/g, absolute value of zeta potential = 31.3 mV, average particle diameter = 46.1 µm) was used instead of activated clay (80 g, manufactured by Mizusawa Industrial Chemicals, Ltd., activated clay V2, mesopore volume = 0.48 cm³/g, absolute value of zeta potential = 35.7 mV, average particle diameter = 28.1 µm). The yield of the resultant polymer compound (P2) = 15%, Mw = 1.16×10⁵, and the mass fraction of components having a molecular weight of 20000 or less = 11.5%.

### <Comparative Example 4>

The same treatment as in Example 1 was conducted except that silica gel (80 g, manufactured by Merck, mesopore volume = 0.72 cm³/g, absolute value of zeta potential = 35.7 mV, average particle diameter = 137.0 µm) was used instead of activated clay (80 g, manufactured by Mizusawa Industrial Chemicals, Ltd., activated clay V2, mesopore volume = 0.48 cm³/g, absolute value of zeta potential = 35.7 mV, average particle diameter = 28.1 µm). The yield of the resultant polymer compound (P2) = 77%, Mw = 1.15×10⁵, and the mass fraction of components having a molecular weight of 20000 or less = 11.8%.

### <Comparative Example 5>

The same treatment as in Example 1 was conducted except that silica gel (80 g, manufactured by Wako Pure Chemical Industries, Ltd., Wakogel® C300, mesopore volume = 0.78 cm³/g, absolute value of zeta potential = 32.6 mV, average particle diameter = 67.5 µm) was used instead of activated clay (80 g, manufactured by Mizusawa Industrial Chemicals, Ltd., activated clay V2, mesopore volume = 0.48 cm³/g, absolute value of zeta potential = 35.7 mV, average particle diameter = 28.1 µm). The yield of the resultant polymer compound (P2) = 82%, Mw = 1.16×10⁵, and the mass fraction of components having a molecular weight of 20000 or less = 11.4%.

### <Comparative Example 6>

The same treatment as in Example 1 was conducted except that activated carbon (80 g, manufactured by Osaka Gas Chemicals Co., Ltd., Carborafine, mesopore volume = 1.49 cm³/g, absolute value of zeta potential = 9.4 mV, average particle diameter = 45.6 µm) was used instead of activated clay (80 g, manufactured by Mizusawa Industrial Chemicals, Ltd., activated clay V2, mesopore volume = 0.48 cm³/g, absolute value of zeta potential = 35.7 mV, average particle diameter = 28.1 µm). The yield of the resultant polymer compound (P2) = 69%, Mw = 1.18×10⁵, and the mass fraction of components having a molecular weight of 20000 or less = 10.5% .

### <Comparative Example 7>

The polymer compound (P1) obtained in Production Example 1 was dissolved in toluene, to prepare a 1.3% by mass solution (308 g). To this solution was added toluene (160 g), and the mixture was stirred for 30 minutes.

The resultant solution was dropped into methanol (2000 g) at 22°C, and the mixture was further stirred for 30 minutes.

The deposited solid was taken out by filtration, and dried, to obtain a polymer compound in the form of solid. The yield of the resultant polymer compound (P2) = 95%, Mw = 1.15×10⁵, and the mass fraction of components having a molecular weight of 20000 or less = 11.8%.

**[Table 1]**

| | Treatment method | Mesopore volume (cm³/g) | Mass fraction of component having molecular weight of 20000 or less (%) | adsorbent |
|---|---|---|---|---|
| Example 1 | Treated by column chromatography | 0.48 | 7.3 | Activated clay |
| Example 2 | Treated by column chromatography | 0.32 | 6. 9 | Activated carbon |
| Example 3 | Treated by column chromatography | 0.39 | 7 . 7 | Activated clay |
| Comparative Example 1 | Treated by solution stirring | 0.48 | 11.2 | Activated clay |
| Comparative Example 2 | Treated by column chromatography | 0.28 | 11.6 | Acid clay |
| Comparative Example 3 | Treated by column chromatography | 0.27 | 11.5 | Activated alumina |
| Comparative Example 4 | Treated by column chromatography | 0.72 | 11.8 | Silica gel |
| Comparative Example 5 | Treated by column chromatography | 0.78 | 11.4 | Silica gel |
| Comparative Example 6 | Treated by column chromatography | 1.49 | 10.5 | Activated carbon |
| Comparative Example 7 | (Treated by reprecipitation) | - | 11.8 | - |

As shown in Table 1, it became clear that the content of low molecular weight components in a polymer compound can be sufficiently decreased in Examples 1 to 3 adopting the production method of the present invention, as compared with Comparative Examples 1 to 7 adopting other production methods.

In Examples 1 to 3 and Comparative Examples 1 to 7, the mass fractions of low molecular weight (molecular weight: 20000 or less) components were all measured using the polymer compound (P2) after performing the reprecipitation treatment. It can be understood from Comparative Example 7 that the method of the present invention of performing a column chromatography treatment using a prescribed amount of a prescribed adsorbent contributes significantly to the effect of reducing the mass fraction of low molecular weight components in a polymer compound, since the mass fraction of low molecular weight components remains unchanged at 11.8% with the reprecipitation treatment itself.

### <Production Example 2>

A polymer compound (P3) represented by the following formula (B) was produced according to a description of Example 4 of JP-A No. 2012-036388. Mw = 1.18×10⁵, and the mass fraction of components having a molecular weight of 20000 or less = 8.5%. 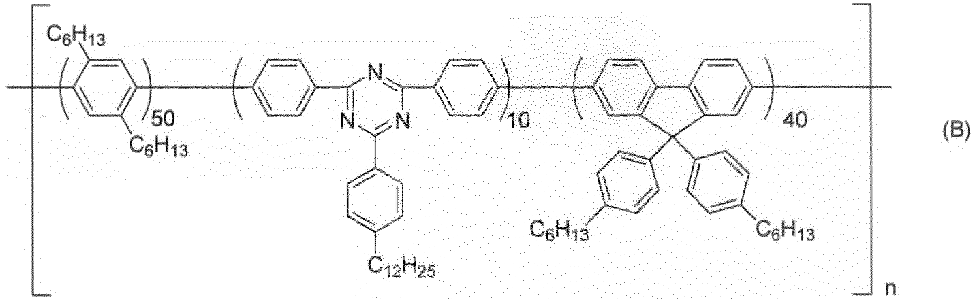 n = degree of polymerization

### <Example 4>

The polymer compound (P3) obtained in Production Example 2 was dissolved in toluene, to prepare a 1.0% by mass solution (400 g). A column tube was filled with activated carbon (80 g, manufactured by Osaka Gas Chemicals Co., Ltd., SHIRASAGI® M, mesopore volume = 0.33 cm³/g, absolute value of zeta potential = 20.3 mV, average particle diameter = 42.4 µm), and it was impregnated with toluene (160 g), then, the above-described solution was added and allowed to pass through. The resultant toluene solution was dropped into methanol (2000 g) at 22°C, and the mixture was further stirred for 30 minutes. The deposited solid was taken out by filtration, and dried, to obtain a polymer compound in the form of solid. The yield of the resultant polymer compound (P4) = 25%, Mw = 1.49×10⁵, and the mass fraction of components having a molecular weight of 20000 or less = 1.2%.

### <Comparative Example 8>

The polymer compound (P3) obtained in Production Example 2 was dissolved in toluene, to prepare a 1.0% by mass solution (400 g). To this solution was added toluene (160 g), and the mixture was stirred for 30 minutes.

The resultant solution was dropped into methanol (2000 g) at 22°C, and the mixture was further stirred for 30 minutes.

The deposited solid was taken out by filtration, and dried, to obtain a polymer compound in the form of solid. The yield of the resultant polymer compound (P4) = 99%, Mw = 1.18×10⁵, and the mass fraction of components having a molecular weight of 20000 or less = 8.7%.

### <Comparative Example 9>

The same treatment as in Example 4 was conducted except that silica gel (80 g, manufactured by Merck, mesopore volume = 0.72 cm³/g, absolute value of zeta potential = 35.7 mV, average particle diameter = 137.0 µm) was used instead of activated carbon (80 g, manufactured by Osaka Gas Chemicals Co., Ltd., SHIRASAGI® M, mesopore volume = 0.33 cm³/g, absolute value of zeta potential = 20.3 mV, average particle diameter = 42.4 µm). The yield of the resultant polymer compound (P4) = 99%, Mw = 1.18×10⁵, and the mass fraction of components having a molecular weight of 20000 or less = 8.7%.

### <Comparative Example 10>

The same treatment as in Example 4 was conducted except that acid clay (80 g, manufactured by Mizusawa Industrial Chemicals, Ltd., acid clay #300, mesopore volume = 0.28 cm³/g, absolute value of zeta potential = 35.0 mV, average particle diameter = 21.0 µm) was used instead of activated carbon (80 g, manufactured by Osaka Gas Chemicals Co., Ltd., SHIRASAGI® M, mesopore volume = 0.33 cm³/g, absolute value of zeta potential = 20.3 mV, average particle diameter = 42.4 µm). The yield of the resultant polymer compound (P4) = 98%, Mw = 1.18×10⁵, and the mass fraction of components having a molecular weight of 20000 or less = 8.7%.

**[Table 2]**

| | Treatment method | Mesopore volume (cm³/g) | Mass fraction of component having molecular weight of 20000 or less (%) | adsorbent |
|---|---|---|---|---|
| Example 4 | Treated by column chromatography | 0.33 | 1. 2 | Activated carbon |
| Comparative Example 8 | (Treated by reprecipitation) | - | 8.7 | - |
| Comparative Example 9 | Treated by column chromatography | 0.72 | 8.7 | Silica gel |
| Comparative Example 10 | Treated by column chromatography | 0.28 | 8.7 | Acid clay |

As shown in Table 2, it became clear that the content of low molecular weight components in a polymer compound can be sufficiently decreased in Example 4 adopting the production method of the present invention, as compared with Comparative Examples 8 to 10 adopting other production methods.

### Industrial Applicability

According to the production method of the present invention, a polymer compound in which the content of low molecular weight components is sufficiently low can be produced. The resultant polymer compounds are suitably used as materials for organic EL devices and the like.

## Claims

1. A method of purifying a polymer compound A containing a constitutional unit represented by the formula (1) to produce a polymer compound B containing a constitutional unit represented by the formula (1) in which low molecular weight components are reduced, wherein
said purification includes a step of treating a mixture containing said polymer compound A and a solvent by column chromatography using an adsorbent,
the filling amount of the adsorbent in said column is 300 parts by mass or more with respect to 100 parts by mass of said polymer compound A,
and the mesopore volume of said adsorbent is 0.3 to 0.7 cm³/g: 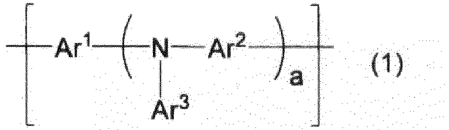 wherein,
Ar¹ and Ar² each independently represent a divalent aromatic hydrocarbon group, a divalent hetero ring group, or a divalent group in which a divalent aromatic hydrocarbon group and a divalent hetero ring group are bonded, and these groups optionally have a substituent, when a plurality of Ar² are present, they may be the same or different,
Ar³ represents a monovalent aromatic hydrocarbon group or a monovalent hetero ring group, and these groups optionally have a substituent, when a plurality of Ar³ are present, they may be the same or different,
a represents an integer of 0 to 2.

2. The production method according to Claim 1, wherein said adsorbent is at least one selected from the group consisting of activated clay and activated carbon.

3. The production method according to Claim 1 or 2, wherein the weight-average molecular weight of said polymer compound A is over 20000.

4. The production method according to any one of Claims 1 to 3, further including a step of performing a reprecipitation treatment, after the step of performing said column chromatography treatment.

5. A method of purifying a polymer compound A having a constitutional unit represented by the formula (1), wherein
said purification includes a step of treating a mixture containing said polymer compound A and a solvent by column chromatography using an adsorbent,
the filling amount of the adsorbent in said column is 300 parts by mass or more with respect to 100 parts by mass of said polymer compound A,
and the mesopore volume of said adsorbent is 0.3 to 0.7 cm³/g: 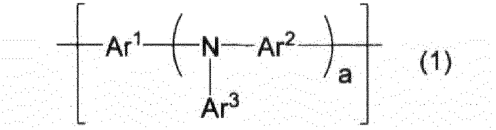 wherein,
Ar¹ and Ar² each independently represent a divalent aromatic hydrocarbon group, a divalent hetero ring group, or a divalent group in which a divalent aromatic hydrocarbon group and a divalent hetero ring group are bonded, and these groups optionally have a substituent, when a plurality of Ar² are present, they may be the same or different,
Ar³ represents a monovalent aromatic hydrocarbon group or a monovalent hetero ring group, and these groups optionally have a substituent, when a plurality of Ar³ are present, they may be the same or different,
a represents an integer of 0 to 2.
